# EUROPÄISCHE PATENTSCHRIFT

(11) **EP 3 280 053 B1**
(45) Veröffentlichungstag und Bekanntmachung des Hinweises auf die Patenterteilung: **01.09.2021**
(21) Anmeldenummer: 17175748.7
(22) Anmeldetag: 13.06.2017
(51) Int. Cl.: H03K 17/96

(54) **BEDIENMODUL FÜR EIN HAUSHALTSGERÄT**
OPERATING MODULE FOR A DOMESTIC APPLIANCE
MODULE DE COMMANDE POUR UN APPAREIL MÉNAGER

(30) Priorität: 15.07.2016 DE 102016212995
(43) Veröffentlichungstag der Anmeldung: 07.02.2018
(73) Patentinhaber: BSH Hausgeräte GmbH, 81739 München (DE)
(72) Erfinder: Stopko, Peter, 04023 Kosice (SK); Zei, Carsten, 93161 Sinzing (DE); Makhtyuk, Roman, 93087 Alteglofsheim (DE); Grauvogl, Erwin, 93161 Sinzing (DE); Wagner, Alexander, 83278 Traunstein (DE)

(56) Entgegenhaltungen:
- EP-A1- 2 166 815
- WO-A1-2015/090361
- DE-A1-102014 213 792
- US-A1- 2010 259 497
- US-A1- 2015 075 960

## Beschreibung

Die Erfindung betrifft ein Bedienmodul für ein Haushaltsgerät, aufweisend eine auf einer Befestigungsfläche eines Trägers aufgebrachte Folie mit mindestens einem berührungsempfindlichen Tastfeld, welche Befestigungsfläche unterhalb des mindestens einen Tastfelds einen Leuchtbereich aufweist. Die Erfindung betrifft auch ein Haushaltsgerät mit mindestens einem solchen Bedienmodul. Die Erfindung ist insbesondere vorteilhaft anwendbar auf Bedienmodule für Kochfelder.

Ein derartiges Bedienmodul ist aus der WO 2015/090361 bekannt. Das Bedienmodul weist eine bedruckte Leiterplatte und eine Lichtquelle auf. Die Leiterplatte ist mit einer ersten, nicht leitfähigen Schicht ausgestattet. Diese weist eine Öffnung auf, durch welche das Licht der Lichtquelle scheint, um ein Bild zu visualisieren.

US 2010/259497 A1 offenbart ein User-Interface mit einem Substrat, auf dem die Elektrode eines Berührsensors aufgebracht ist. Die Elektrode weist dabei eine Öffnung auf, durch die Licht projiziert wird.

Aus der DE 10 2014 213 792 A1 ist eine elektronische Benutzerschnittstelle mit wenigstens einem Ein- und/oder Ausgabemittel bekannt. Das Ein- und/oder Ausgabemittel ist dabei mittels eines Halters mechanisch an einer Leiterplatte der Benutzerschnittstelle befestigt.

EP 2 166 815 A1 offenbart eine Heizvorrichtung zum Kochen mit einer oberen Platte, die einen Bedienbereich aufweist. An der Rückseite des Bedienbereichs sind zahlreiche Elektroden mit Aussparungen zum Erfassen einer Berührung des Bedienbereichs ausgebildet. An einer Elektrodenunterseite sind lichtemittierende Bauteile angeordnet.

US 2015/075960 beschreibt ein Touch-Panel mit einem Substrat und einer darauf angebrachten, dekorativen Schicht. Das Substrat weist zudem eine leitfähige ElektrodenStruktur auf.

WO 2015/014436 A1 offenbart eine berührungs- und/oder annäherungsempfindliche Eingabevorrichtung. Die Eingabevorrichtung enthält eine Abdeckplatte mit einem Bedienabschnitt, wobei eine einem Benutzer der Eingabevorrichtung zugewandte Seite des Bedienabschnitts ein Bedienfeld für den Benutzer und eine dem Benutzer abgewandte Seite des Bedienabschnitts eine Sensorebene bildet; eine Sensorfolie auf einer dem Benutzer abgewandten Seite der Abdeckplatte mit wenigstens einem kapazitiven Sensorfeld im Bereich des Bedienabschnitts der Abdeckplatte; eine Trägerplatte auf einer dem Benutzer abgewandten Seite der Sensorfolie, auf welcher wenigstens ein elektrisches Kontaktfeld vorgesehen ist; und wenigstens ein elektrisches Kontaktelement zwischen der Trägerplatte und der Sensorfolie, um das wenigstens eine Sensorfeld der Sensorfolie elektrisch leitend mit dem wenigstens einen elektrischen Kontaktfeld der Trägerplatte zu verbinden. Um sowohl eine räumliche Adaption der Sensorfelder an zum Beispiel eine Bedienblende eines elektronischen Haushaltsgerätes als auch deren zuverlässige elektrische Kontaktierung zu erzielen, ist vorgesehen, dass die Abdeckplatte einen Kontaktierungsabschnitt aufweist, der in einer Richtung der Sensorebene neben dem Bedienabschnitt angeordnet ist und dessen dem Benutzer abgewandte Seite eine Kontaktierungsebene bildet; die Sensorfolie wenigstens ein elektrisches Kontaktfeld aufweist, welches in einer Richtung der Sensorebene neben dem wenigstens einen Sensorfeld angeordnet ist und elektrisch leitend mit dem wenigstens einen Sensorfeld verbunden ist; und das wenigstens eine elektrische Kontaktelement das wenigstens eine elektrische Kontaktfeld der Sensorfolie elektrisch leitend mit dem wenigstens einen elektrischen Kontaktfeld der Trägerplatte verbindet.

WO 2004/107062 A1 offenbart eine Sensorvorrichtung für einen kapazitiven Berührungsschalter, die ein Flachmaterial aufweist, welches aus einer durchsichtigen Trägerfolie und einer ITO-Beschichtung besteht. Die ITO-Beschichtung ist elektrisch leitfähig und durchsichtig. Ein solches Flachmaterial kann zur Bildung eines Sensorelements zwischen einer durchsichtigen Abdeckung und einer Leuchtanzeige angeordnet werden. Die Darstellung eines beleuchteten Symbols oder einer entsprechenden Anzeige ist durch das Flachmaterial bzw. das Sensorelement hindurch möglich.

EP 1 814 227 A2 offenbart, dass bei einer Bedieneinrichtung für ein Kochfeld mit einem LC-Display vorgesehen sein kann, dass auf die Oberseite der unteren von zwei Platten des LC-Display ein Mikrocontroller als Halbleiterchip direkt aufgebracht ist, beispielsweise durch COG-Technik. Dieser Halbleiterchip steuert nicht nur das LC-Display an, sondern auch an dem LC-Display angeordnete kapazitive Sensorelemente und wertet diese auch aus. So wird eine eigenständige Baueinheit gebildet. Diese kann über geeignete elektrische Verbindungen mit dem Kochfeld verbunden sein und dieses unter Umständen zumindest teilweise oder sogar ganz steuern.

DE 10 2010 064 236 A1 offenbart ein Kochfeld mit einer Elektronikplatine, die ein Anzeige- und/oder Bedienelement aufweist und an zumindest einem Halteelement in einem Platinengehäuse befestigt ist. Dabei ist das Halteelement als Federelement ausgebildet, um eine Oberfläche des Anzeige- und/oder Bedienelements an eine Innenoberfläche einer Kochfeldabdeckung zu drücken.

Dabei ist es bisher nachteilig, dass in einem kompakt und einfach aufgebauten Bedienfeld angezeigte, beleuchtete Symbole häufig einen diffusen Rand zeigen oder sich merklich gegenseitig beleuchten (optischer Crosstalk).

Es ist die Aufgabe der vorliegenden Erfindung, die Nachteile des Standes der Technik zumindest teilweise zu überwinden und insbesondere ein einfach und kompakt aufbaubares Bedienfeld bereitzustellen, das mit preisgünstigen Mitteln Symbole o.ä. präzise und mit einer hohen Detailgenauigkeit beleuchten darstellen kann.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst durch ein Bedienmodul für ein Haushaltsgerät, aufweisend einen Träger mit einer Befestigungsfläche, auf welcher eine Diffusionsfolie aufgeklebt ist. Auf die Diffusionsfolie ist eine Symbolfolie aufgeklebt, wobei die Symbolfolie mindestens ein berührungsempfindliches Tastfeld aufweist, das jeweils eine Metallschicht mit mindestens einer eingebrachten Aussparung aufweist. Die Metallschicht ist elektrisch leitend mit einem elektrischen Anschluss der Symbolfolie verbunden. Die Befestigungsfläche weist unterhalb des mindestens einen Tastfelds einen Leuchtbereich zum Hinterleuchten des Tastfelds auf. Weiterhin ist die Diffusionsfolie mit mindestens einer lichtdurchlässigen Sperrlage versehen, die jeweils Fenster im Bereich des mindestens einen Tastfelds aufweist. Das mindestens eine Tastfeld ragt dabei seitlich über das jeweils zugehörige Fenster hinaus. Die Symbolfolie ist unterhalb der Metallschicht lichtabsorbierend ausgebildet, indem unterhalb einer transparenten Grundfolie der Symbolfolie, an der die Metallschicht oberseitig aufgebracht ist, eine lichtabsorbierende Schicht vorhanden ist, wobei die lichtabsorbierende Schicht deckungsgleich unterhalb der Metallschicht angeordnet ist.

Dieses Bedienmodul weist den Vorteil auf, dass das Tastfeld mit rückseitig beleuchtbaren Aussparungen versehen ist, die sich durch eine besonders hohe Präzision und Detailgenauigkeit ihrer optischen Darstellung auszeichnen. Dabei wird ausgenutzt, dass nachträglich in eine Metallschicht eingebrachte Aussparungen präziser und mit einer weit höheren Auflösung hergestellt werden können als wenn die Aussparungen bei der Herstellung der Metallschicht durch Freilassung (z.B. bei einem Druckverfahren) hergestellt werden. Zudem lässt sich eine besonders niedrigere Bauhöhe bei kostengünstiger Herstellung des Bedienmoduls erreichen. Darüber hinaus lässt sich die Symbolfolie auf einfache und preisgünstige Weise variieren, z.B. zur Erzeugung von Bedienmodulen für unterschiedliche Bedienfelder. Darüber hinaus ist ein solches Bedienmodul robust und zudem einfach austauschbar (z.B. im Kundendienstfall).

Das Bedienmodul kann ein Bedienfeld sein oder einen Teil eines Bedienfelds des Haushaltsgeräts darstellen. Insbesondere kann das Bedienmodul unter einer lichtdurchlässigen Glasplatte oder Glaskeramikplatte eines Kochfelds angeordnet sein. Mittels des Bedienfelds kann das Kochfeld (z.B. zugehörige Kochstellen) bedient werden. Ist das Haushaltsgerät ein Herd, kann mittels des Bedienfelds auch der zugehörige Ofen bedient werden. Jedoch kann das Haushaltsgerät auch ein anderes Gargerät sein, z.B. ein Dampfgarer. Das Haushaltsgerät kann auch ein Wäschebehandlungsgerät, ein Kühlgerät, ein Geschirrbehandlungsgerät (Spülmaschine, Sterilisator usw.) sein. Das Bedienmodul für das Haushaltsgerät kann auch als ein "Haushaltsgeräte-Bedienmodul" bezeichnet werden.

Das Bedienmodul kann ein solches Tastfeld oder mehrere solche Tastfelder aufweisen. Bei mehreren Tastfeldern sind diese insbesondere voneinander elektrisch isoliert.

Die Befestigungsfläche des Trägers ist insbesondere eine ebene Seite des Trägers, beispielsweise dessen Oberseite. Der Träger kann einen Kunststoffkörper aufweisen. Der Träger kann eine quaderförmige Grundform aufweisen.

Das berührungsempfindliche Tastfeld kann z.B. ein resistives, kapazitives (z.B. oberflächen-kapazitiver oder projiziert-kapazitiver) oder induktives Tastfeld sein. Das Tastfeld kann auch als Tastbereich, "Touchfeld" oder "Touchtaste" bezeichnet werden. Das berührungsempfindliche Tastfeld kann - insbesondere zusammen mit einer Abdeckung (z.B. einer Glasplatte oder Glaskeramikplatte) - ein Bedienelement eines Bedienfelds bilden.

Das Tastfeld ist mittels des Leuchtbereichs hinterleuchtbar. Folglich sieht ein Betrachter des Bedienmoduls im eingebauten Zustand die Aussparungen als beleuchtet oder hinterleuchtet an, da dort das von dem Leuchtbereich abgestrahlte Licht hindurchtreten kann.

Einem Leuchtbereich kann genau ein Tastfeld zugeordnet sein. Alternativ oder zusätzlich können einem Leuchtbereich mehrere Tastfelder zugeordnet sein, also mehrere Tastfelder mittels des gleichen Leuchtbereichs hinterleuchtbar sein.

Dass in die Metallschicht mindestens eine Aussparung eingebracht worden ist, bedeutet insbesondere, dass die Aussparung nachträglich in die Metallschicht eingebracht worden ist. Die Metallschicht eines Tastfelds kann also insbesondere zunächst eine flächig durchgehende Metallschicht gewesen sein, die dann entsprechend lokal entfernt worden ist.

Es ist eine Weiterbildung, dass auch Lücken zwischen Metallschichten unterschiedlicher Tastfelder o.ä. nachträglich eingebracht worden sind. Dies ergibt den Vorteil, dass als Ausgangsfolie oder Halbzeug eine durchgehend mit einer Metallschicht belegte Folie verwendet werden kann.

Es ist eine Weiterbildung, dass die Metallschicht eine Kupferschicht ist. Diese ist besonders elektrisch leitfähig. Die Metallschicht kann aber auch aus Aluminium o.ä. bestehen. Die Metallschicht kann oberflächenbehandelt sein, z.B. verzinnt sein oder verzinkt sein.

Es ist eine Weiterbildung, dass die mindestens eine in der Metallschicht eines Tastfelds eingebrachte Aussparung in Symbolform vorliegt, da so einem Betrachter eine Funktion des zugehörigen Tastfelds besonders einfach vermittelbar ist. Die Symbolform kann ein graphisches Symbol, ein Icon, eine Ziffer, ein Buchstabe oder eine Kombination daraus sein oder darstellen.

Damit eine Berührung des Tastfelds einer anderen Komponente des Haushaltsgeräts (z.B. einem Steuergerät) übermittelt werden kann, weist die Symbolfolie einen elektrischen Anschluss auf, der mit den Metallschichten der jeweiligen Tastfelder elektrisch verbunden ist, z.B. über entsprechende Leiterbahnen. Der Anschluss kann pro angeschlossenem Tastfeld einen elektrischen Kontakt aufweisen.

Es ist eine Weiterbildung, dass das Bedienmodul mindestens ein nicht berührungsempfindliches Feld ("Anzeigefeld") aufweist, das analog zu einem Tastfeld ausgebildet ist, aber nicht mit dem elektrischen Anschluss der Symbolfolie verbunden ist. Dies gibt den Vorteil, dass auch reine Anzeigefelder mit einer besonders hohen Präzision und Detailgenauigkeit ihrer optischen Darstellung bereitgestellt werden können. Folglich kann die Symbolfolie auch mindestens ein nicht berührungsempfindliches Anzeigefeld aufweisen, unterhalb dessen der Träger bzw. die Befestigungsfläche mindestens einen Leuchtbereich aufweist, und das mindestens eine Anzeigefeld jeweils eine Metallschicht mit mindestens einer eingebrachten Aussparung aufweist.

Die Symbolfolie weist eine, insbesondere flexible, Grundfolie aus lichtdurchlässigem Kunststoff auf. Die Grundfolie kann auch als Ausgangs- oder Basisfolie bezeichnet werden. Der Kunststoff kann transparent oder diffus streuend sein. Transparenter Kunststoff erhöht eine Lichtausbeute und erzeugt besonders scharfe optische Kanten der Symbole, transparent oder diffus streuender Kunststoff kann eine Gleichmäßigkeit einer Leuchtdichte im Bereich der Aussparung(en) verbessern. Die Metallschicht ist auf der Grundfolie aufgebracht.

Die Metallschicht kann beispielsweise eine galvanisch aufgebrachte Metallschicht sein.

Es ist eine Ausgestaltung, dass die mindestens eine Aussparung mindestens eine durch Materialabtrag in die Metallschicht eingebrachte Aussparung ist. Dies ist besonders vorteilhaft, da ein Materialabtrag preiswert und - z.B. im Vergleich zu einem Metalldruck - mit hoher Präzision durchgeführt werden kann.

Es ist eine Weiterbildung, dass die mindestens eine Aussparung mindestens eine in die Metallschicht eingeätzte Aussparung ist. Dies ist vorteilhaft, da Metallätzen preiswert und - z.B. im Vergleich zu einem Metalldruck - mit besonders hoher Präzision durchgeführt werden kann. Das Metallätzen kann im Rahmen eines fotolithografischen Prozesses durchgeführt werden.

Es ist noch eine Weiterbildung, dass die mindestens eine Aussparung mindestens eine durch Lasertrennung in die Metallschicht eingebrachte Aussparung ist. Auch die Lasertrennung kann preiswert mit hoher Präzision durchgeführt werden. Es ist auch eine Weiterbildung, dass die mindestens eine Aussparung mindestens eine durch Stanzen in die Metallschicht eingebrachte Aussparung ist. Stanzen kann besonders preiswert durchgeführt werden.

Es ist noch eine Ausgestaltung, dass durch die mindestens eine Aussparung getrennte Teilbereiche der Metallschicht mittels mindestens eines elektrisch leitfähigen Stegs miteinander verbunden sind. Dadurch wird eine elektrische Kontaktierung aller Teilbereiche erreicht, um eine hohe Empfindlichkeit des Tastfelds bei Berührung beizubehalten, und zwar auch bei komplex geformten Aussparungen bzw. Symbolen. Der Steg wird für Anzeigefelder nicht gebraucht, kann aber grundsätzlich vorhanden sein.

Der Steg kann insbesondere ein dünner Steg in dem Sinne sein, dass er zum optischen Eindruck der mindestens einen Aussparung nicht oder nicht wesentlich beiträgt bzw. einen optischen Eindruck der mindestens einen Aussparung nicht beeinträchtigt. In einer Sichtweise können durch einen dünnen Steg beabstandete Aussparungen Teile einer einzigen Aussparung angesehen werden; alternativ können durch einen dünnen Steg beabstandete Aussparungen als zwei unterschiedliche Aussparungen angesehen werden.

Es ist eine weitere Ausgestaltung, dass die Metallschicht des mindestens einen Tastfelds mittels einer jeweiligen Leiterbahn mit einem elektrischen Anschlusselement verbunden ist. So lässt sich eine elektrische Verbindung der Symbolfolie mit einer Verarbeitungseinheit (z.B. einer zentralen Steuereinrichtung) zuverlässig herstellen. Das elektrische Anschlusselement kann z.B. ein mechanischer Stecker, eine Kontaktierfeder (insbesondere einer Gruppe von Kontaktierfedern) oder ein festangelöteter Stecker sein.

Es ist noch eine weitere Ausgestaltung, dass die Metallschicht des mindestens einen Tastfelds mittels einer jeweiligen Leiterbahn mit einem FPC ("Flexible Printed Circuit")-Anschluss verbunden ist. Das elektrische Anschlusselement ist also ein FPC-Anschluss. Ein solcher Anschluss lässt sich besonders einfach und preiswert an Folien ausbilden. Bei mehreren Tastfeldern können diese mittels einer jeweiligen Leiterbahn mit einem elektrischen Kontakt des FPC-Anschlusses verbunden sein.

Die Symbolfolie ist im Bereich der Metallschicht außerhalb der mindestens einen Aussparung lichtabsorbierend ausgebildet. Damit wird verhindert, dass das Licht von einer Oberfläche der Metallschicht unter Farbaufnahme (aufgrund einer Farbe der Metallschicht) zurück zum Leuchtbereich reflektiert wird und dann (z.B. aufgrund von Mehrfachreflektion) von dem Leuchtbereich wieder in Richtung der Metallschicht und der Aussparungen geworfen wird. Dadurch wiederum wird verhindert, dass Licht mit einem Farbstich durch die Aussparungen gestrahlt wird. Dieser Farbstich kann durch Transmissionseigenschaften einer Abdeckung aus Glas oder Glaskeramik zusätzlich verstärkt werden. Diese Ausgestaltung ist besonders vorteilhaft einsetzbar, falls der Leuchtbereich originär weißes Licht abstrahlt, da ein Betrachter dabei auf Farbabweichungen besonders empfindlich reagiert. Diese Ausgestaltung ist besonders vorteilhaft einsetzbar bei einer Metallschicht aus Kupfer, da durch die rötliche Kupferfarbe ein deutlicher Rotstich hervorgerufen werden kann. Es ist dabei eine lichtabsorbierende Schicht an einer Unterseite des folienartigen Grundkörpers angebracht, welche also von der Metallschicht durch den Grundkörper getrennt ist, wobei die lichtabsorbierende Schicht deckungsgleich unterhalb der Metallschicht angeordnet ist.

Es ist eine Weiterbildung, dass die Symbolfolie oberhalb der Metallschicht (d.h., an ihrer vom Träger abgewandten Seite) lichtabsorbierend ausgebildet ist. Dies kann beispielsweise dadurch erreicht werden, dass die Metallschicht oberseitig mit einer nicht oder nur schlecht reflektierenden Schicht versehen ist.

Zwischen der Symbolfolie und dem Träger ist eine lichtdurchlässige Streufolie oder Diffusorfolie angeordnet. Die Diffusorfolie sorgt für eine besonders gleichmäßige (diffuse) Ausleuchtung oder Hinterleuchtung der Aussparung(en) in der mindestens einen Metallschicht der darüber liegenden Symbolfolie. Die Die Diffusorfolie kann z.B. aus lichtstreuendem Kunststoff bestehen.

Die Diffusorfolie ist mit mindestens einer lichtundurchlässigen (optischen) Sperrlage (auch als Blockierschicht oder Blockierlage bezeichenbar) versehen, die jeweils Fenster unterhalb des mindestens einen Tastfelds bzw. der zugehörigen Metallschicht aufweist, wobei das mindestens eine Tastfeld bzw. die zugehörige Metallschicht seitlich über das jeweils zugehörige Fenster herausragt. Die mindestens eine Sperrlage unterdrückt oder verhindert eine interne, horizontale Ausbreitung des Lichts in der Diffusorfolie und /oder eine folgende großflächigere Abstrahlung in Richtung der Symbolfolie, und damit den sog. optischen Crosstalking-Effekt, insbesondere bei eng benachbarten Tast- und/oder Anzeigefeldern (z.B. bei Segmentanzeigen wie 7-Segment-Anzeigen). Durch die Fenster wird das Licht von dem Leuchtbereich zu den Aussparungen der Metallschicht durchgelassen.

Die Diffusorfolie kann nur eine unterseitige (dem Träger gegenüberliegende) Sperrlage, nur eine oberseitige (der Symbolfolie gegenüberliegende) Sperrlage oder sowohl eine unterseitige Sperrlage als auch eine oberseitige Sperrlage aufweisen. Die Fenster überdecken sich dann zumindest teilweise so, dass Licht von dem zugehörigen Leuchtbereich durch beide Fenster zu den Aussparungen des darüber liegenden Tastfelds gelangen kann.

Die Sperrlage kann aufgedruckt sein und dann als ein "Sperrdruck" bezeichnet werden.

Erfindungsgemäß ragt die Metallschicht eines Tast- oder Anzeigebereichs allseitig seitlich (z.B. bei Draufsicht auf die Symbolfolie) über das mindestens eine Fenster der Diffusorfolie hinaus. Damit lässt sich eine unerwünschte Beleuchtung im Randbereich des Tastfelds verhindern.

Es ist auch eine Ausgestaltung, dass die Diffusorfolie oberseitig mit einer ersten Sperrlage versehen ist und unterseitig mit einer zweiten Sperrlage versehen ist und ein einem gleichen Tastenbereich zugeordnetes Fenster der ersten Sperrlage seitlich innerhalb eines Fensters der zweiten Sperrlage liegt. In anderen Worten ist das oberseitige Fenster geringfügig kleiner (insbesondere allseitig kleiner) als das unterseitige Fenster. Das obere Fenster liegt (z.B. bei Draufsicht auf die Symbolfolie) also innerhalb des unteren Fensters. Dadurch können Toleranzen zwischen der ersten, oberseitigen Sperrlage und der zweiten, unterseitigen Sperrlage ausgeglichen werden, um optischen Crosstalk besonders effektiv zu unterbinden.

Die Diffusorfolie ist auf der Befestigungsfläche des Trägers aufgeklebt und die Symbolfolie ist auf die Diffusorfolie aufgeklebt. Dadurch wird ein besonders flacher Aufbau des Bedienmoduls erreicht. Die Diffusorfolie und die Symbolfolie können dazu unterseitig mit einer jeweiligen Haft- oder Kleberschicht versehen sein. Diese Kleberschichten sind insbesondere an den Tastfeldern ausgespart, um eine Beeinflussung der Lichtausstrahlung durch die Aussparungen und/oder nachteilige Lichtausbreitungen aufgrund des Haftmittels zu verhindern. Zusätzlich können die Diffusorfolie und/oder die Symbolfolie auch anders als stoffschlüssig befestigt sein, beispielsweise durch eine kraftschlüssige und /oder formschlüssige Befestigung, beispielsweise durch Anpressen mittels Klammern, Aufstecken auf Stifte usw.

Es ist außerdem noch eine Ausgestaltung, dass die Leuchtbereiche Öffnungen von Lichtschächten des Trägers an dessen Befestigungsfläche sind. Dies ergibt den Vorteil einer bereits stark vergleichmäßigten Lichtverteilung an den Leuchtbereichen aufgrund einer Reflexion von Licht an den Wänden der Lichtschächte. Zudem wird so eine teilweise Lichtkollimation erreicht, was eine Leuchtdichte an den Aussparungen erhöht. Es ist eine zur effektiven Reflexion von Licht an den Wänden der Lichtschächte vorteilhafte Weiterbildung, dass die (Seiten-)Wände der Lichtschächte reflektierend ausgebildet sind, insbesondere diffus reflektierend. Licht kann insbesondere an einer dem Leuchtbereich abgewandten (unteren) Öffnung des Lichtschachts eingestrahlt werden bzw. kann eine Lichtquelle im Bereich einer dem Leuchtbereich abgewandten (unteren) Öffnung des Lichtschachts angeordnet sein. Dadurch ist der Lichtschacht der Lichtquelle optisch nachgeschaltet. Alternativ können die Leuchtbereiche z.B. Abdeckungen der Lichtschächte sein oder - ohne Verwendung von Lichtschächten - Abdeckungen jeweiliger Lichtquellen sein.

Es ist zudem eine Ausgestaltung, dass der Träger mindestens eine LED-Platine mit jeweils mindestens einer LED aufweist und die Lichtschächte der mindestens einen LED optisch nachgeschaltet sind. Der Träger kann insbesondere eine LED-Platine mit mehreren LEDs aufweisen. Diese Ausgestaltung ergibt den Vorteil, dass die Lambertsche Lichtverteilung der LEDs durch die Lichtschächte teilweise kollimiert wird. Zudem sind LEDs preiswert und weisen eine lange Lebensdauer auf. Insbesondere können weißes Licht abstrahlende LEDs verwendet werden. Die LED-Platine kann platzsparend in dem Träger untergebracht werden. Die LEDs können auch OLEDs sein.

Es ist eine Weiterbildung, dass jedem Lichtschacht mindestens eine eigene LED zugeordnet ist, also keine LED mehrere Lichtschächte beleuchtet. Der Lichtschacht kann z.B. eine rechteckige Grundform oder eine sich trichterförmig zur Symbolfolie hin öffnende Grundform aufweisen. Die trichterförmige Grundform kann z.B. eine pyramidenstumpfartige Grundform sein. Die Lichtschächte können reflektierend ausgebildet sein.

Es ist noch eine Weiterbildung, dass das Bedienmodul nur den Träger mit der daran angeordneten LED-Platine, die auf der Befestigungsfläche des Trägers aufgeklebte Diffusorfolie und die auf der Diffusorfolie aufgeklebte Symbolfolie aufweist.

Die Aufgabe wird auch gelöst durch ein Haushaltsgerät, aufweisend mindestens ein Bedienmodul wie oben beschrieben. Das Haushaltsgerät kann analog zu dem Bedienmodul ausgebildet sein und ergibt die gleichen Vorteile.

Das Haushaltsgerät kann ein Gargerät sein. Das Gargerät kann insbesondere ein Kochfeld aufweisen. Das Gargerät kann ein eigenständiges Kochfeld oder eine Kochfeld/Ofen-Kombination (Herd) sein.

Für den Fall, dass das Gargerät ein Kochfeld aufweist, kann sich das Bedienmodul unter einer lichtdurchlässigen Kochfeldplatte, z.B. aus Glas oder Glaskeramik befinden. Die Tastfelder bzw. deren Metallschichten kontaktieren vorteilhafterweise eine Unterseite der Kochfeldplatte, um auf menschliche Berührungen an der Oberseite der Kochfeldplatte oberhalb des Tastfelds empfindlich reagieren zu können.

Ein elektrischer Anschluss der Symbolfolie kann mit einer Steuereinrichtung des Haushaltsgeräts verbunden sein.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden schematischen Beschreibung eines Ausführungsbeispiels, das im Zusammenhang mit den Zeichnungen näher erläutert wird.
- Fig.1: zeigt als Explosionsdarstellung in Schrägansicht ein Bedienmodul;
- Fig.2: zeigt in Schrägansicht das Bedienmodul aus Fig.1 in einem zusammengesetzten Zustand;
- Fig.3A: zeigt in Draufsicht eine Metallschicht eines Tastfelds des Bedienmoduls;
- Fig.3B: zeigt in Draufsicht eine Metallschicht eines Anzeigefelds des Bedienmoduls;
- Fig.4A: zeigt in Draufsicht einen Ausschnitt des Bedienmoduls im Bereich eines Tastfelds; und
- Fig.4B: zeigt als Schnittdarstellung in Seitenansicht einen Ausschnitt aus einem Kochfeld mit dem Bedienmodul im Bereich des Tastfelds aus Fig.4A.

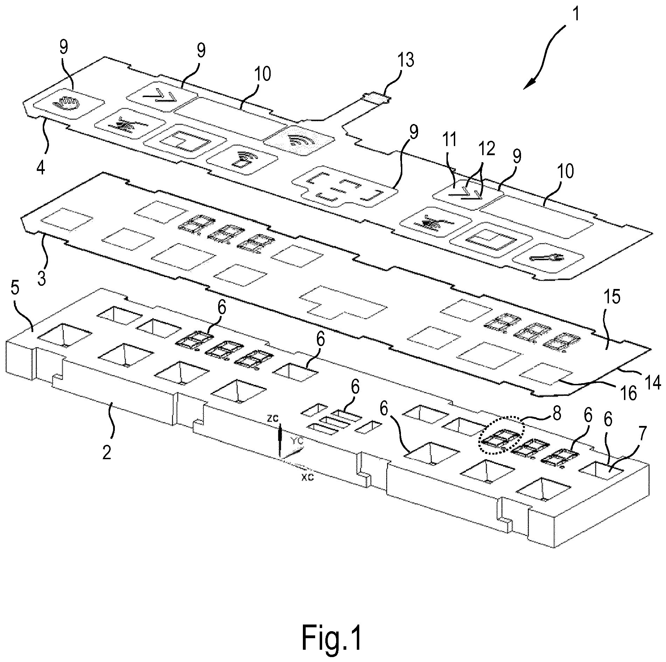

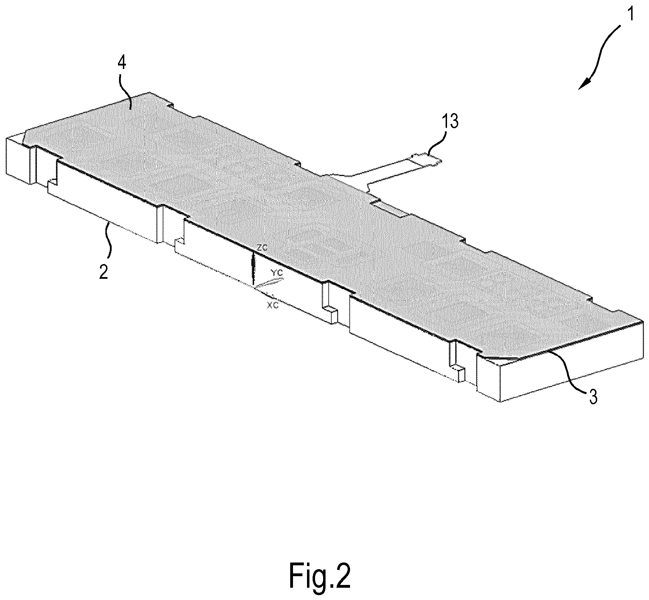

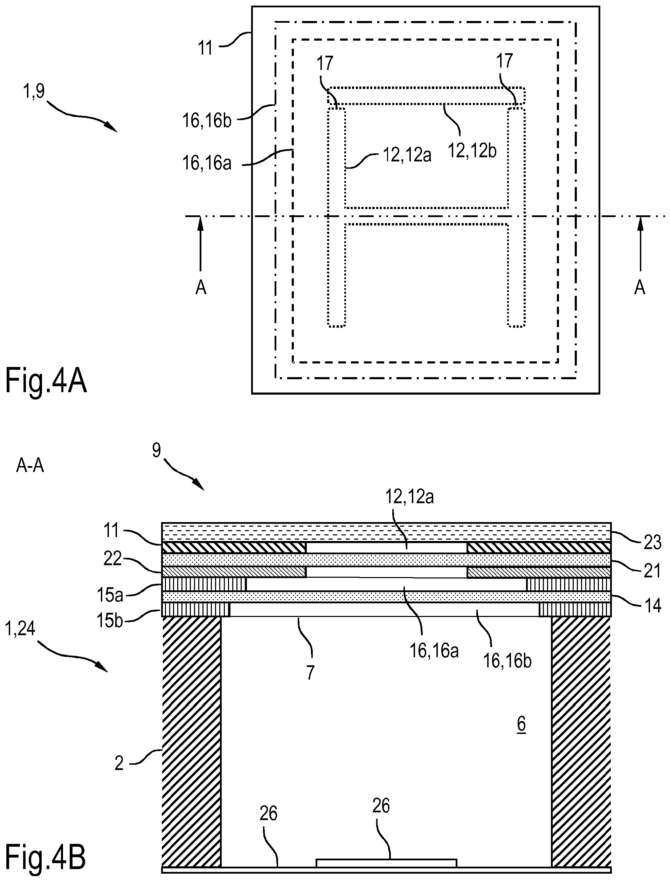

Fig.1 zeigt als Explosionsdarstellung in einer Ansicht von schräg oben ein Bedienmodul 1 mit einem (unteren) Träger 2, einer darauf angeordneten (mittleren) Diffusorfolie 3 und einer darauf angeordneten (oberen) Symbolfolie 4. Das Bedienmodul kann z.B. zur Verwendung mit einem Kochfeld 24 (siehe Fig.4B) vorgesehen sein. Fig.2 zeigt das Bedienmodul 1 in einem fertig zusammengesetzten Zustand.

Der Träger 2 ist ein quaderförmiges Spritzgussteil aus Kunststoff und weist eine der Diffusorfolie 3 und der Symbolfolie 4 zugewandte Befestigungsfläche 5 auf, die seiner Oberseite entspricht. Die Diffusorfolie 3 ist mit ihrer Unterseite auf der Befestigungsfläche 5 aufgeklebt, und die Symbolfolie 4 ist mit ihrer Unterseite auf einer Oberseite der Diffusorfolie 3 aufgeklebt, z.B. mittels geeigneter Haftschichten (o. Abb.).

Der Träger 2 weist mehrere senkrecht verlaufende, durchgehende Lichtschächte 6 auf, deren obere Öffnungen in der Befestigungsfläche 5 entsprechende Leuchtbereiche 7 bilden. Beispielsweise können unterschiedliche Lichtschächte 6 bzw. Leuchtbereiche 7 für jeweilige Segmente einer Segmentanzeige (z.B. sieben Lichtschächte 6 für eine Siebensegmentanzeige 8) vorgesehen sein.

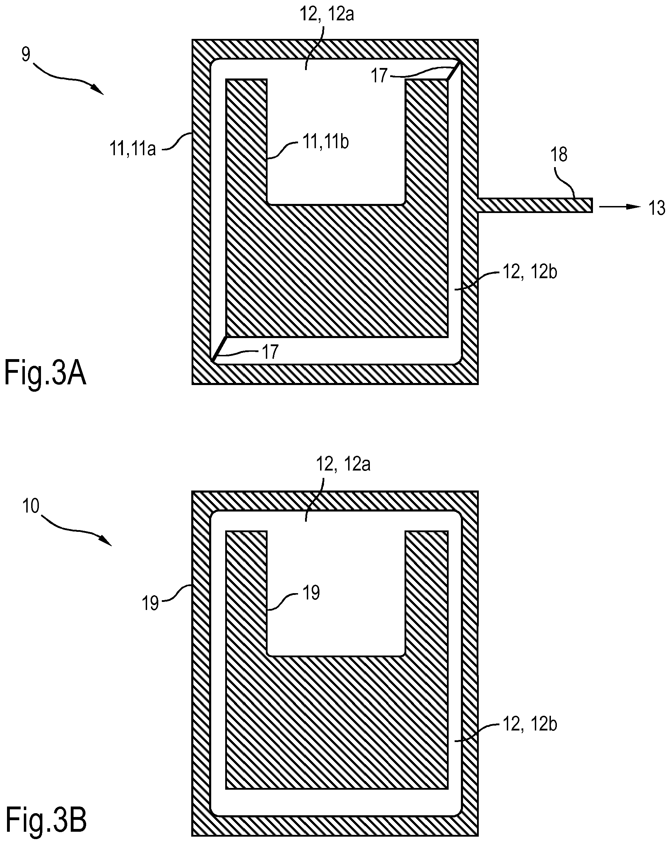

Die Leuchtbereiche 7 sind unterhalb von berührungsempfindlichen Tastfeldern 9 oder nicht berührungsempfindlichen Anzeigefeldern 10 der Symbolfolie 4 angeordnet, um diese zu beleuchten, insbesondere zu hinterleuchten. Die Tastfelder 9 weisen Kupferschichten 11 auf, aus denen nachträglich jeweils mindestens eine Aussparung 12 eingeätzt worden ist. Die Kupferschichten 11 sind auf einer transparenten Kunststofffolie (Grundfolie 21, siehe Fig.4B) aufgebracht. Die Anzeigefelder 10 können ähnlich aufgebaut sein oder-z.B. im Fall einer Segmentanzeige - als eine einfache nicht-metallisierte Fläche ausgebildet sein. Die Kupferschichten 11 der Tastfelder 9 sind elektrisch leitend mit einem elektrischen Anschluss der Symbolfolie 4 in Form eines FPC-Anschlusses 13 verbunden, und zwar mittels Leiterbahnen 18 (siehe Fig.3A). Jede der Leiterbahnen 18 kann zu einem jeweiligen elektrischen Kontakt des FPC-Anschlusses 13 führen bzw. einen solchen Kontakt bilden. Die Aussparungen 12 der Tastfelder 9 bilden Symbole (z.B. Pfeile, Icons, Ziffern, Buchstaben usw.), die mittels der Leuchtbereiche 7 hinterleuchtbar sind und dann aufgrund eines Lichtdurchlasses einem Betrachter leuchtend erscheinen.

Zur Vergleichmäßigung einer Helligkeit des durch die Aussparungen 12 hindurchgestrahlten Lichts weist die Diffusorfolie 3 eine lichtstreuende Folie 14 als Grundkörper auf. Die Folie 14 ist zumindest einseitig mit einer lichtundurchlässigen optischen Sperrlage 15 belegt, welche Sperrlage 15 Fenster 16 zwischen den Leuchtbereichen 7 und den Aussparungen 12 aufweist.

Fig.3A zeigt in Draufsicht eine Kupferschicht 11 eines möglichen Tastfelds 9. Das Tastfeld 9 weist zwei durch dünne, optisch unauffällige Stege 17 getrennte Aussparungen 12a, 12b auf. Dies kann auch als eine Aussparung 12 verstanden werden, welche durch die zwei Stege 17 gequert wird, um die beiden ansonsten voneinander elektrisch getrennten Teilbereiche 11a und 11b der Kupferschicht 11 elektrisch miteinander zu verbunden. Einer der Teilbereiche 11a ist über eine sich anschließende Leiterbahn 18 aus Kupfer mit dem FPC-Anschluss 13 verbunden.

Fig.3B zeigt in Draufsicht eine Kupferschicht 19 eines möglichen Anzeigefelds 10 des Bedienmoduls 1. Um ein ähnliches leuchtendes Symbol wie in Fig.3A darzustellen, kann auf die Stege 17 verzichtet werden. Auch kann auf die Leiterbahn 18 verzichtet werden.

Fig.4A zeigt in Draufsicht einen Ausschnitt des Bedienmoduls 1 im Bereich eines weiteren Tastfelds 9. Fig.4B zeigt als Schnittdarstellung in Seitenansicht auf eine Schnittfläche A-A einen Ausschnitt aus einem Kochfeld 24 mit dem Bedienmodul 1 im Bereich des Tastfelds 9 aus Fig.4A.

Die Kupferschicht 11 mit seiner Aussparung 12 bzw. seinen Aussparungen 12, 12b steht allseitig über ein oberes Fenster 16, 16a über, das in einer oberseitig an der lichtstreuenden Folie 14 der Diffusorfolie 3 angebrachten lichtundurchlässigen Sperrlage 15, 15a eingebracht ist. Die Kupferschicht 11 steht auch allseitig über ein unteres Fenster 16, 16b über, das in einer unterseitig an der lichtstreuenden Folie 14 der Diffusorfolie 3 angebrachten Sperrlage 15, 15b eingebracht ist. In anderen Worten ragt das Tastfeld 9 bzw. dessen Kupferschicht 11 seitlich über die Fenster 16a und 16b hinaus. Das untere Fenster 16b ist dabei seitlich umlaufend größer als das obere Fenster 16a. Das obere Fenster 16a liegt also bei Draufsicht allseitig innerhalb des unteren Fensters 16b.

Die Symbolfolie 4 ist unterhalb der Kupferschicht 11 dadurch lichtabsorbierend ausgebildet, dass unterhalb der transparenten Grundfolie 21 der Symbolfolie 4 (an dem die Kupferschicht 11 oberseitig aufgebracht ist) eine lichtabsorbierende Schicht 22 vorhanden ist. Die lichtabsorbierende Schicht 22 ist deckungsgleich unterhalb der Kupferschicht 11 angeordnet.

Die Kupferschicht 11 liegt an einer Unterseite einer Glas- oder Glaskeramikplatte 23 eines Kochfelds 24 auf und wird an die Glas- oder Glaskeramikplatte 23 angedrückt. Ein Nutzer kann eine Oberseite der Glas- oder Glaskeramikplatte 23 berühren und so ein kapazitiv oder induktiv ausgelöstes elektrische Signal an dem Tastfeld 9 erzeugen, das über die Leiterbahn 18 am FPC-Anschluss 13 abgegriffen werden kann. Der FPC-Anschluss 13 kann mit einer Steuereinheit (o. Abb.) des Kochfelds 24 verbunden sein.

An einer Unterseite des Trägers 2 ist eine LED-Platine 25 mit mehreren LEDs 26 angebracht. Jedem Lichtschacht 6 ist eine eigene LED 26 zugeordnet. Die LEDs 26 können unabhängig voneinander betreibbar sein, so dass auch die Leuchtbereiche 7 unabhängig voneinander zum Leuchten gebracht werden können. Von einer LED 26 abgestrahltes, z.B. weißes, Licht wird teilweise direkt durch die Aussparungen 12 und teilweise nach Reflexion an einer Innenwand des Lichtschachts 6 nach außen gestrahlt. Dabei werden auch das untere Fenster 16b, die lichtstreuende Folie 14, das obere Fenster 16a, ein Fenster in der lichtabsorbierenden Schicht 22, die transparente Grundfolie 21 und die Glas- oder Glaskeramikplatte 23 von dem Licht durchlaufen.

Selbstverständlich ist die vorliegende Erfindung nicht auf das gezeigte Ausführungsbeispiel beschränkt.

Allgemein kann unter "ein", "eine" usw. eine Einzahl oder eine Mehrzahl verstanden werden, insbesondere im Sinne von "mindestens ein" oder "ein oder mehrere" usw., solange dies nicht explizit ausgeschlossen ist, z.B. durch den Ausdruck "genau ein" usw.

Auch kann eine Zahlenangabe genau die angegebene Zahl als auch einen üblichen Toleranzbereich umfassen, solange dies nicht explizit ausgeschlossen ist.

Die lichtabsorbierende Schicht 22 ist insbesondere deckungsgleich unterhalb der Kupferschicht 11 angeordnet.

Die Kupferschicht 11 liegt an einer Unterseite einer Glas- oder Glaskeramikplatte 23 eines Kochfelds 24 auf und wird an die Glas- oder Glaskeramikplatte 23 angedrückt. Ein Nutzer kann eine Oberseite der Glas- oder Glaskeramikplatte 23 berühren und so ein kapazitiv oder induktiv ausgelöstes elektrische Signal an dem Tastfeld 9 erzeugen, das über die Leiterbahn 18 am FPC-Anschluss 13 abgegriffen werden kann. Der FPC-Anschluss 13 kann mit einer Steuereinheit (o. Abb.) des Kochfelds 24 verbunden sein.

An einer Unterseite des Trägers 2 ist eine LED-Platine 25 mit mehreren LEDs 26 angebracht. Jedem Lichtschacht 6 ist eine eigene LED 26 zugeordnet. Die LEDs 26 können unabhängig voneinander betreibbar sein, so dass auch die Leuchtbereiche 7 unabhängig voneinander zum Leuchten gebracht werden können. Von einer LED 26 abgestrahltes, z.B. weißes, Licht wird teilweise direkt durch die Aussparungen 12 und teilweise nach Reflexion an einer Innenwand des Lichtschachts 6 nach außen gestrahlt. Dabei werden auch das untere Fenster 16b, die lichtstreuende Folie 14, das obere Fenster 16a, ein Fenster in der lichtabsorbierenden Schicht 22, die transparente Grundfolie 21 und die Glas- oder Glaskeramikplatte 23 von dem Licht durchlaufen.

Selbstverständlich ist die vorliegende Erfindung nicht auf das gezeigte Ausführungsbeispiel beschränkt.

Allgemein kann unter "ein", "eine" usw. eine Einzahl oder eine Mehrzahl verstanden werden, insbesondere im Sinne von "mindestens ein" oder "ein oder mehrere" usw., solange dies nicht explizit ausgeschlossen ist, z.B. durch den Ausdruck "genau ein" usw.

Auch kann eine Zahlenangabe genau die angegebene Zahl als auch einen üblichen Toleranzbereich umfassen, solange dies nicht explizit ausgeschlossen ist.

### Bezugszeichenliste

- 1: Bedienmodul
- 2: Träger
- 3: Diffusorfolie
- 4: Symbolfolie
- 5: Befestigungsfläche
- 6: Lichtschacht
- 7: Leuchtbereich
- 8: Siebensegmentanzeige
- 9: Tastfeld
- 10: Anzeigefeld
- 11: Kupferschicht
- 11a: Teilbereich der Kupferschicht
- 11b: Teilbereich der Kupferschicht
- 12: Aussparung
- 12a: Aussparung
- 12b: Aussparung
- 13: FPC-Anschluss
- 14: Folie
- 15: Sperrlage
- 15a: obere Sperrlage
- 15b: untere Sperrlage
- 16: Fenster
- 16a: Oberes Fenster
- 16b: Unteres Fenster
- 17: Steg
- 18: Leiterbahn
- 19: Kupferschicht
- 21: Grundfolie
- 22: Lichtabsorbierende Schicht
- 23: Glaskeramikplatte
- 24: Kochfeld
- 25: LED-Platine
- 26: LED

## Patentansprüche

1. Bedienmodul (1) für ein Haushaltsgerät (24), aufweisend
- einen Träger (2) mit einer Befestigungsfläche (5),
- eine Diffusorfolie (3), die auf der Befestigungsfläche (5) des Trägers (2) aufgeklebt ist und
- eine Symbolfolie (4), die auf die Diffusorfolie (3) aufgeklebt ist,
wobei
- die Symbolfolie (4) mindestens ein berührungsempfindliches Tastfeld (9) aufweist, das jeweils eine Metallschicht (11) mit mindestens einer eingebrachten Aussparung (12) aufweist und die Metallschicht (11) elektrisch leitend mit einem elektrischen Anschluss (13) der Symbolfolie (4) verbunden ist,
- die Befestigungsfläche (5) unterhalb des mindestens einen Tastfelds (9) einen Leuchtbereich (7) zum Hinterleuchten des Tastfelds (9) aufweist,
- die Diffusorfolie (3) mit mindestens einer lichtundurchlässigen Sperrlage (19, 15) versehen ist, die jeweils Fenster (16a, 16b) im Bereich des mindestens einen Tastfelds (9) aufweist,
- das mindestens eine Tastfeld (9) seitlich über das jeweils zugehörige Fenster (16a, 16b) hinausragt und
wobei
- die Symbolfolie (4) unterhalb der Metallschicht (11) lichtabsorbierend ausgebildet ist, indem unterhalb einer transparenten Grundfolie (21) der Symbolfolie (4), an der die Metallschicht (11) oberseitig aufgebracht ist, eine lichtabsorbierende Schicht (22) vorhanden ist, wobei die lichtabsorbierende Schicht (22) deckungsgleich unterhalb der Metallschicht (11) angeordnet ist.

2. Bedienmodul (1) nach Anspruch 1, **dadurch gekennzeichnet, dass** die mindestens eine Aussparung (12, 12a, 12b) mindestens eine durch Materialabtrag in die Metallschicht (11) eingebrachte Aussparung ist, wobei die mindestens eine Aussparung (12, 12a, 12b) getrennte Teilbereiche (12a, 12b) der Metallschicht (12) mittels mindestens eines elektrisch leitfähigen Stegs (17) miteinander verbunden sind.

3. Bedienmodul (1) nach Anspruch 2, **dadurch gekennzeichnet, dass** die Metallschicht des mindestens einen Tastfelds (9) mittels einer jeweiligen Leiterbahn (18) mit einem elektrischen Kontaktelement des elektrischen Anschlusses (13) verbunden ist und die Metallschicht des mindestens einen Tastfelds (9) mittels einer jeweiligen Leiterbahn (18) mit einem FPC-Anschluss (13) verbunden ist.

4. Bedienmodul (1) nach einem der vorhergehenden Ansprüche, **dadurch gekennzeichnet, dass** die Symbolfolie (4) zusätzlich oberhalb der Metallschicht (11) lichtabsorbierend ausgebildet ist.

5. Bedienmodul (1) nach Anspruch 4, **dadurch gekennzeichnet, dass** die Metallschicht mit einer nicht oder nur schlecht reflektierenden Schicht versehen ist.

6. Bedienmodul (1) nach einem der vorhergehenden Ansprüche, **dadurch gekennzeichnet, dass** die Metallschicht (11) aus Kupfer besteht.

7. Bedienmodul (1) nach einem der vorhergehenden Ansprüche, **dadurch gekennzeichnet, dass**
- die Diffusorfolie (3) oberseitig mit einer ersten Sperrlage (15a) versehen ist und unterseitig mit einer zweiten Sperrlage (15b) versehen ist und
- ein einem gleichen Tastenfeld (9) zugeordnetes Fenster (16, 16a) der ersten Sperrlage (15a) seitlich innerhalb eines Fensters (16, 16b) der zweiten Sperrlage (15b) liegt.

8. Bedienmodul (1) nach einem der vorhergehenden Ansprüche, **dadurch gekennzeichnet, dass** die Leuchtbereiche (7) Öffnungen von Lichtschächten (6) des Trägers (2) an dessen Befestigungsfläche (5) sind.

9. Bedienmodul (1) nach Anspruch 8, **dadurch gekennzeichnet, dass** der Träger (2) mindestens eine LED-Platine (25) mit jeweils mindestens einer LED (26) aufweist und die Lichtschächte (6) den LEDs (26) optisch nachgeschaltet sind.

10. Haushaltsgerät (24), aufweisend ein Bedienmodul (1) nach einem der vorhergehenden Ansprüche.

11. Haushaltsgerät (24) nach Anspruch 10, bei dem das Haushaltsgerät (24) ein Gargerät ist, das ein Kochfeld aufweist, wobei sich das Bedienmodul (1) unter einer lichtdurchlässigen Kochfeldplatte (23) befindet und die Metallschicht (11) eine Unterseite der Kochfeldplatte (23) kontaktiert.

## Claims

1. Operating module (1) for a household appliance (24), having
- a support (2) with a fastening surface (5),
- a diffusor film (3) which is bonded to the fastening surface (5) of the carrier (2) and
- a symbol film (4) which is bonded to the diffusor film (3),
wherein
- the symbol film (4) has at least one touch-sensitive touch pad (9), which has a metal layer (11) in each case, with at least one recess (12) introduced, and the metal layer (11) is connected to an electrical connection (13) of the symbol film (4) in an electrically conductive manner,
- the fastening surface (5) has a lighting region (7) beneath the at least one touch pad (9) for back-lighting the touch pad (9),
- the diffusor film (3) is provided with at least one light-impermeable prohibiting layer (19, 15), which has a window (16a, 16b) in each case in the region of the at least one touch pad (9),
- the at least one touch pad (9) protrudes laterally beyond the associated window (16a, 16b) in each case and
wherein
- the symbol film (4) is configured as light-absorbent beneath the metal layer (11), in that there is a light-absorbent layer (22) beneath a transparent base film (21) of the symbol film (4), to which the metal layer (11) is applied on the upper side, wherein the light-absorbent layer (22) is congruently arranged beneath the metal layer (11).

2. Operating module (1) according to claim 1, **characterised in that** the at least one recess (12, 12a, 12b) is at least one recess applied to the metal layer (11) by removing material, wherein subsections (12a, 12b) of the metal layer (12) separated the at least one recess (12, 12a, 12b) are connected to one another by means of at least one electrically conductive web (17).

3. Operating module (1) according to claim 2, **characterised in that** the metal layer of the at least one touch pad (9) is connected to an electrical contact element of the electrical connection (13) by means of a conductor path (18) in each case and the metal layer of the at least one touch pad (9) is connected to an FPC connection (13) by means of a conductor path (18) in each case.

4. Operating module (1) according to one of the preceding claims, **characterised in that** the symbol film (4) is configured as light absorbent in addition above the metal layer (11).

5. Operating module (1) according to claim 4, **characterised in that** the metal layer is provided with one non-reflecting or poorly reflecting layer.

6. Operating module (1) according to one of the preceding claims, **characterised in that** the metal layer (11) is made of copper.

7. Operating module (1) according to one of the preceding claims, **characterised in that**
- the diffusor film (3) is provided with a first prohibiting layer (15a) on the upper side and with a second prohibiting layer (15b) on the underside and
- a window (16, 16a) of the first prohibiting layer (15a) arranged on a same touch pad (9) lies laterally within a window (16, 16b) of the second prohibiting layer (15b).

8. Operating module (1) according to one of the preceding claims, **characterised in that** the lighting regions (7) are openings of light shafts (6) of the support (2) on its fastening surface (5).

9. Operating module (1) according to claim 8, **characterised in that** the support (2) has at least one LED printed circuit board (25) with at least one LED (26) in each case and the light shafts (6) are optically downstream of the LEDs (26).

10. Household appliance (24), having an operating module (1) according to one of the preceding claims.

11. Household appliance (24) according to claim 10, in which the household appliance (24) is a cooking appliance that has a hob, wherein the operating module (1) is located beneath a light-permeable hob plate (23) and the metal layer (11) makes contact with an underside of the hob plate (23).

## Revendications

1. Module de commande (1) pour un appareil ménager (24), présentant
- un support (2) doté d'une surface de fixation (5),
- un film translucide (3) qui est collé sur la surface de fixation (5) du support (2), et
- un film de symboles (4) qui est collé sur le film translucide (3),
dans lequel
- le film de symboles (4) présente au moins un champ de touches (9) tactile, lequel présente respectivement une couche métallique (11) comprenant au moins un évidement (12) inséré, et dans lequel la couche métallique (11) est reliée de manière électroconductrice à un raccord électrique (13) du film de symboles (4),
- la surface de fixation (5) présente en dessous de l'au moins un champ de touches (9) une zone d'éclairage (7) destinée à rétroéclairer le champ de touches (9),
- le film translucide (3) est muni d'au moins une couche barrière (19, 15) imperméable à la lumière, laquelle présente respectivement des fenêtres (16a, 16b) dans la zone de l'au moins un champ de touches (9),
- l'au moins un champ de touches (9) fait saillie latéralement au-delà de la fenêtre (16a, 16b) respectivement correspondante, et
dans lequel
- le film de symboles (4) est réalisé de manière à absorber la lumière en dessous de la couche métallique (11), du fait qu'en dessous d'un film de base transparent (21) du film de symboles (4), sur lequel la couche métallique (11) est appliquée côté supérieur, une couche (22) absorbant la lumière est présente, la couche (22) absorbant la lumière étant disposée en dessous de la couche métallique (11) de manière coïncidente.

2. Module de commande (1) selon la revendication 1, **caractérisé en ce que** l'au moins un évidement (12, 12a, 12b) est au moins un évidement inséré par enlèvement de matière dans la couche métallique (11), dans lequel les zones partielles (12a, 12b) de la couche métallique (12) séparées par l'au moins un évidement (12, 12a, 12b) sont reliées entre elles au moyen d'au moins une nervure (17) électroconductrice.

3. Module de commande (1) selon la revendication 2, **caractérisé en ce que** la couche métallique de l'au moins un champ de touches (9) est reliée à un élément de contact électrique du raccord électrique (13) au moyen de respectivement une piste respective (18), et **en ce que** la couche métallique de l'au moins un champ de touches (9) est reliée à un raccord FPC (13) au moyen d'une piste respective (18).

4. Module de commande (1) selon l'une quelconque des revendications précédentes, **caractérisé en ce que** le film de symboles (4) est réalisé en outre de manière absorbant la lumière au-dessus de la couche métallique (11).

5. Module de commande (1) selon la revendication 4, **caractérisé en ce que** la couche métallique est munie d'une couche non réfléchissante ou seulement peu réfléchissante.

6. Module de commande (1) selon l'une quelconque des revendications précédentes, **caractérisé en ce que** la couche métallique (11) est constituée de cuivre.

7. Module de commande (1) selon l'une quelconque des revendications précédentes, **caractérisé en ce que**
- le film translucide (3) est muni côté supérieur d'une première couche barrière (15a), et côté inférieur d'une seconde couche barrière (15b), et
- **en ce qu'**une fenêtre (16, 16a), attribuée à un champ de touche identique (9), de la première couche barrière (15a) est située latéralement à l'intérieur d'une fenêtre (16, 16b) de la seconde couche barrière (15b).

8. Module de commande (1) selon l'une quelconque des revendications précédentes, **caractérisé en ce que** les zones d'éclairage (7) sont des ouvertures de puits de lumière (6) du support (2) sur la surface de fixation (5) de ce dernier.

9. Module de commande (1) selon la revendication 8, **caractérisé en ce que** le support (2) présente au moins une platine à LED (25) comprenant respectivement au moins une LED (26), et **en ce que** les puits de lumière (6) sont optiquement installés en aval des LED (26).

10. Appareil ménager (24) présentant un module de commande (1) selon l'une quelconque des revendications précédentes.

11. Appareil ménager (24) selon la revendication 10, dans lequel l'appareil ménager (24) est un appareil de cuisson qui présente une table de cuisson, dans lequel le module de commande (1) se trouve en dessous d'une plaque (23) de table de cuisson perméable à la lumière, et la couche métallique (11) met en contact un côté inférieur de la plaque (23) de table de cuisson.
